# EUROPÄISCHE PATENTSCHRIFT

(11) **EP 0 630 535 B1**
(45) Veröffentlichungstag und Bekanntmachung des Hinweises auf die Patenterteilung: **30.08.1995**
(21) Anmeldenummer: 93905341.9
(22) Anmeldetag: 11.03.1993
(51) Int. Cl.: H03C 3/09

(54) **MIT EINEM EINEN GLEICHANTEIL AUFWEISENDEN MODULATIONSSIGNAL MODULIERBARE PLL-SCHALTUNG**
PLL CIRCUIT MODULATABLE BY A MODULATION SIGNAL HAVING A DIRECT CURRENT COMPONENT
CIRCUIT PLL MODULABLE PAR UN SIGNAL DE MODULATION COMPORTANT UNE COMPOSANTE DE COURANT CONTINU

(30) Priorität: 30.04.1992 DE 4214385
(43) Veröffentlichungstag der Anmeldung: 28.12.1994
(73) Patentinhaber: FRAUNHOFER-GESELLSCHAFT ZUR FÖRDERUNG DER ANGEWANDTEN FORSCHUNG E.V., 80636 München (DE)
(72) Erfinder: HEUBERGER, Albert, D-91056 Erlangen (DE); WALLRAPP, Ludwig, D-91058 Erlangen (DE); SEITZER, Dieter, D-91054 Erlangen (DE)
(74) Vertreter: Schoppe, Fritz, Dipl.-Ing.
(86) Internationale Anmeldenummer: EP9300559
(87) Internationale Veröffentlichungsnummer: WO9322829

(56) Entgegenhaltungen:
- EP-A- 0 044 155
- EP-A- 0 215 651
- WO-A-89/07865
- US-A- 3 622 913
- ELECTRONICS Bd. 53, Nr. 19, 28. August 1980, NEW YORK Seiten 133 - 142 FRED TELEWSKI U.A. 'DELAY LINES GIVE GENERATOR SPECTRAL PURITY, PROGRAMMABILITY'

## Beschreibung

Die vorliegende Erfindung betrifft eine mit einem einen Gleichanteil aufweisenden Modulationssignal modulierbare PLL-Schaltung nach dem Oberbegriff des Patentanspruchs 1.

Eine typische PLL-Schaltung ist derart angeordnet, daß die Modulation gegen die PLL-Regelschleife erfolgt. Typischerweise hat eine derartige PLL-Schaltung einen spannungsgesteuerten Oszillator, dem eingangsseitig ein Summensignal zugeführt wird, welches einerseits das Modulationssignal und andererseits das Ausgangssignal oder Fehlersignal eines Phasendetektors umfaßt.

Der Ausgang des spannungsgesteuerten Oszillators bildet gleichzeitig den Ausgang der PLL-Schaltung, welcher über eine Teilerschaltung zu einem Phasenvergleicher zurückgeführt wird, dem ein festes Referenzsignal zugeführt wird. Die Phasendifferenz wird dem Schleifenfilter zugeführt. Bei dieser einfachen PLL-Schaltung wirkt das Modulationssignal als Störung, die durch die Phasenregelschleife nicht ausgeregelt werden kann. Daher muß nötigerweise die geringste Modulationsfrequenz größer als die Schleifenbandbreite des Schleifenfilters sein. Als vorteilhaft ist diese Standard-PLL-Schaltung dahingehend anzusehen, daß eine einfache Kanaleinstellung vorgenommen werden kann, da die Ausgangsfrequenz der PLL-Schaltung dem Produkt des Teilerverhältnisses des Teilers mit der Bezugsfrequenz entspricht. Für sämtliche Ausgangsfrequenzen ist der gleiche Referenzquarz verwendbar. Die Schaltung ermöglicht einen linearen Frequenzmodulationshub. Eine derartige Schaltung ermöglicht Schrittweiten von 10 kHz bei vernünftiger Referenzunterdrückung. Wie bereits ausgeführt, eignet sich eine derartige PLL-Schaltung mit Modulation gegen die PLL-Regelschleife nur für Modulationsfrequenzen, die größer als die Schleifenbandbreite sind. Dies erzwingt die ausschließliche Verwendung von gleichstromfreien Codes zur digitalen Modulation. Anderenfalls würden niedrigere Frequenzanteile im Modulationssignal von der PLL-Regelschleife ausgeregelt.

In der Sendertechnik bedingt daher die Verwendung einer PLL-Schaltung mit Modulation gegen die PLL-Regelschleife die Verwendung gleichstromfreier Codes. Dies macht eine Umcodierung eines eingangsseitigen NRZ-Datenstromes in gleichstromfreie, sogenannte Line Codes notwendig. Dabei besteht das Problem, die asynchrone digitale Quelle mit dem Takt der sendereigenen Codierung zu synchronisieren. Daher sind Vorinformationen über das Datenformat der Quelle erforderlich, nämlich insbesondere über die Art des Ruhezustandes (Pausen mit hohem oder niedrigem Pegel), die Art der Synchronisation des Bitstromes (Startbit, Stopbit usw.), die Datenrate, die Anstiegszeit der Signale, die Länge der Telegramme, usw. Derartige Einschränkungen können aufgrund der Forderung nach einer transparenten Übertragung, also einer Übertragung ohne Vorkenntnisse über die Art und das Format des zu übertragenden Signales, nicht hingenommen werden.

Weitere Nachteile einer derartigen Schaltung mit einer Modulation gegen die Regelschleife sind aufgrund der notwendigen niedrigen Schleifenbandbreite deren Empfindlichkeit gegenüber Frequenzmodulationsstörungen durch Mikrophonie und Antennenrückwirkung. Ferner wird das Phasenrauschen durch die Eingangsgüte des VCO-Resonators bestimmt, so daß ein Resonator mit hoher Güte erforderlich ist, der Resonator nur eine geringe Mikrophonieempfindlichkeit aufweisen darf und eine hohe Isolationsdämpfung vom Oszillator zum Ausgang erforderlich ist.

Aus der DE 3533222 A1 ist bereits eine gattungsgemäße PLL-Schaltung bekannt, die zur Modulation mit einem Modulationssignal, das einen Gleichanteil aufweist, geeignet ist. Die bekannte PLL-Schaltung umfaßt einen spannungsgesteuerten Oszillator, dem eingangsseitig einerseits über einen Trennkondensator das Modulationssignal und andererseits ein Fehlersignal von einem Schleifenfilter zugeführt wird. Das ausgangsseitige Signal des Oszillators bildet gleichzeitig das Schaltungsausgangssignal, welches einem Schleifenteiler mit einem festen Schleifenteilerfaktor zugeführt wird. Das Ausgangssignal des Schleifenteilers wird einem Phasenvergleicher zugeführt, dessen zweitem Eingang ein Vergleichsfrequenzsignal zugeführt wird und dessen Ausgang mit dem Schleifenfilter verbunden ist. Das Referenzfrequenzsignal wird über eine Synthesizerschaltung aus dem Modulationssignal gewonnen, indem dieses nach Tiefpaßfilterung einem Analog-Digital-Wandler zugeführt wird, der einen Frequenzgenerator über einen Steuerbus ansteuert. Eine quarzstabile Frequenz wird zusammen mit der vom Frequenzgenerator kommenden Frequenz über einen Mischer und nachgeschalteten Teiler zu der gewünschten Referenzfrequenz zusammengesetzt.

Obwohl diese bekannte Schaltung nicht die eingangs erläuterten Beschränkungen üblicher PLL-Schaltungen mit Modulation gegen die PLL-Regelschleife hat, ist ihr Einsatzgebiet aufgrund der erforderlichen komplexen Schaltungsteile, wie beispielsweise des Analog-Digital-Wandlers und des Frequenzsynthesizers, auf Anwendungsfälle beschränkt, bei denen es auf Kosten und Realisierungsaufwand nicht ankommen darf.

Aus der WO 89/07865 ist ebenfalls eine gattungsgemäße PLL-Schaltung bekannt, die zur Modulation mit einem Modulationssignal geeignet ist. Die bekannte PLL-Schaltung umfaßt einen spannungsgesteuerten Oszillator, dem eingangsseitig einerseits das Modulationssignal und andererseits ein Fehlersignal von einem Schleifenfilter zugeführt wird. Das ausgangsseitige Signal des Oszillators bildet gleichzeitig das Schaltungsausgangssignal, welches einem Schleifenteiler mit einem Schleifenteilerfaktor zugeführt wird. Das Ausgangssignal des Schleifenteilers wird einem Phasendetektor zugeführt, dessen zweiter Eingang mit dem Ausgang eines Referenzteilers mit einem Teilerfaktor verbunden ist, dem ein Referenzoszillator vorgeschaltet ist, wobei das Modulationssignal dem Referenzoszillator zugeführt wird. Der Ausgang des Phasendetektors ist mit dem Schleifenfilter verbunden.

Ausgehend von dem oben gewürdigten Stand der Technik liegt der vorliegenden Erfindung daher die Aufgabe zugrunde, eine PLL-Schaltung der eingangs genannten Art zu schaffen, die trotz Modulierbarkeit mittels eines einen Gleichanteil aufweisenden Modulationssignales mit einfacher Schaltungsstruktur ausgeführt werden kann.

Diese Aufgabe wird durch eine PLL-Schaltung gemäß Patentanspruch 1 gelöst.

Bevorzugte Weiterbildungen der erfindungsgemäßen Schaltung sind in den Unteransprüchen angegeben.

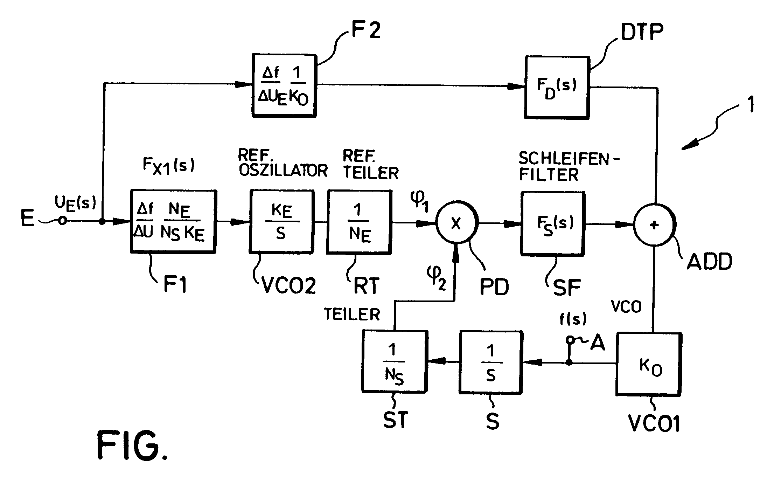

Nachfolgend wird unter Bezugnahme auf die beiliegende Zeichnung ein bevorzugtes Ausführungsbeispiel der erfindungsgemäßen PLL-Schaltung näher erläutert. Es zeigt:
- Die einzige Fig.: ein Blockdiagramm der erfindungsgemäßen PLL-Schaltung.

Die erfindungsgemäße, mit einem einen Gleichanteil aufweisenden Modulationssignal modulierbare PLL-Schaltung ist in der Figur in ihrer Gesamtheit mit dem Bezugszeichen 1 bezeichnet. Sie umfaßt zwei spannungsgesteuerte Oszillatoren, nämlich den spannungsgesteuerten Hauptoszillator VCOl, der auch als spannungsgesteuerter HF-Oszillator bezeichnet werden kann, und den spannungsgesteuerten Referenzoszillator VCO2, der auch als spannungsgesteuerter NF-Oszillator bezeichnet werden kann. Der Ausgang des spannungsgesteuerten Hauptoszillators VCO1 bildet gleichzeitig den Ausgang A der Schaltung 1. Das Ausgangssignal des spannungsgesteuerten Hauptoszillators VCO1 wird einer Integratorschaltung S zugeführt. Die Integratorschaltung S stellt einen idealen Integrator im Sinne der Laplace-Transformation dar.

Der Ausgang der Integratorschaltung S wird einem Schleifenteiler ST zugeführt, der einen Schleifenteilerfaktor N_{S} hat. Das sich ergebende Phasensignal wird einem der beiden Eingänge eines Phasenvergleichers PD (mit der Steilheit KP) zugeführt, dessen anderem Eingang ein Vergleichsfrequenzsignal zugeführt wird. Die Erzeugung des Vergleichsfrequenzsignales wird später erläutert.

Der Ausgang des Phasenvergleichers PD wird dem Schleifenfilter SF zugeführt, welcher ausgangsseitig ein Fehlersignal erzeugt, das einem Eingang eines Addierers ADD zugeführt wird, dessen Ausgang mit dem Steuereingang des Hauptoszillators VCO1 in Verbindung steht.

Das Modulationssignal, das an der Schaltung 1 an einem Eingang E anliegt, wird über ein erstes Kompensationsfilter F1 dem spannungsgesteuerten Referenzoszillator VCO2 zugeführt, der seinerseits ausgangsseitig an einen Referenzteiler RT angeschlossen ist. Der Referenzteiler RT ist ausgangsseitig mit dem Referenzfrequenzeingang des Phasenvergleichers PD verbunden.

Das Modulationssignal U_{E} am Eingang E wird ferner über ein zweites Kompensationsfilter F2 und über einen Datentiefpaß DTP dem anderen Eingang des Addierers ADD zugeführt, dessen ersten Eingang das Fehlersignal von dem Schleifenfilter SF zugeführt wird.

Die Übertragungsfunktion F_{X1}(s) des ersten Kompensationsfilters F1 ist proportional zu dem Frequenzhub Delta F des Referenzoszillators VCO2, ferner proportional zu dem Referenzteilerfaktor N_{E} und umgekehrt proportional zu dem Schleifenteilerfaktor N_{S} und der Abstimmsteilheit K_{E} des Referenzoszillators VCO2.

Andererseits ist die Übertragungsfunktion F_{X2}(s) des zweiten Kompensationsfilters F2 proportional zu dem Frequenzhub Delta F des Hauptoszillators VCO1 und umgekehrt proportional zu der Abstimmsteilheit K_{O} des Hauptoszillators VCO1.

Bei der erfindungsgemäßen Schaltung wird mit niedrigen Frequenzanteilen des Modulationssignales U_{E}(s) der Referenzoszillator moduliert, welcher als spannungsgesteuerter Quarzoszillator VCXO ausgeführt sein kann. Mit hohen Frequenzanteilen des Modulationssignales U_{E}(s) findet eine direkte Modulation des spannungsgesteuerten Hauptoszillators VCO1 statt.

Die in den Kompensationsfiltern F1, F2 eingestellten Werte, die die Teilerfaktoren und Oszillatorsteilheiten betreffen, müssen mit den physikalischen Werten der Oszillatoren übereinstimmen. Falls dies nicht der Fall ist, wird der sich ergebende Frequenzmodulationshub frequenzabhängig.

Die niederfrequenten Anteile des Frequenzhubes werden, wie erläutert, vom ersten Kompensationsfilter F1 bestimmt. Die Parameter dieses Filters können, falls erforderlich, prozessorgesteuert eingestellt realisiert werden. In einer Schmalbandversion des Senders ist eine prozessorgesteuerte bzw. softwaregesteuerte Einstellbarkeit des Filters nicht erforderlich, da der einzig veränderliche Parameter, nämlich der Schleifenteilerfaktor N_{S} sich während des Betriebes entsprechend des Bandbreiteverhältnisses ändert.

In einer Breitbandversion des Senders kann es zu Änderungen des Teilerfaktors N_{S} kommen, so daß in diesem Fall eine prozessorgesteuerte Einstellbarkeit des Parameters erforderlich werden kann. In diesem Fall wird man gleichzeitig die prozessorgesteuerte Einstellung des zu wählenden Frequenzhubes Delta F im ersten Kompensationsfilter F1 im unteren Frequenzbereich vornehmen.

Wie erläutert, werden die hochfrequenten Anteile des Frequenzhubes nur von dem zweiten Kompensationsfilter F2 bestimmt und sind daher nur von der Abstimmsteilheit K_{O} des Hauptoszillators VCO1 abhängig. Da dieser Wert stark nichtlinear sein kann, bietet es sich an, diesen Parameter K_{O} des zweiten Kompensationsfilters F2 prozessorgesteuert einzustellen. Gleichfalls ist eine prozessorgesteuerte Einstellbarkeit des Frequenzhubes Delta F für den oberen Frequenzbereich möglich.

Im Frequenzbereich werden Seitenlinien der Trägerfrequenz im Abstand n · Referenzfrequenz von dem Phasenvergleicher PD hervorgerufen. Diese unerwünschten Spektralanteile, die je nach Postvorschriften eine bestimmte Leistung (z. B. -37 dBm) im Nachbarkanal nicht überschreiten dürfen, werden umso größer, je weiter die Phasen vom Referenzoszillator VCO2 und vom Hauptoszillator VCO1 auseinanderliegen.

Bei der idealen Modulation mit und gegen die Phase mittels der erfindungsgemäßen PLL-Schaltung tritt an dem Phasenvergleicher PD keine Phasendifferenz auf, die ausgeregelt werden müßte, so daß im Spektrum keine Referenzlinien hervorgerufen durch die Modulation vorhanden sind. Dies hat den Vorteil, daß die Schleifenbandbreite des Schleifenfilters SF höher gewählt werden kann, bevor die zulässige Leistung im Nachbarkanal überschritten wird. Dies hat den Vorteil, daß die Einflüsse durch Mikrophonie und Antennenrückwirkung geringer werden.

## Patentansprüche

1. Mit einem einen Gleichanteil aufweisenden Modulationssignal modulierbare PLL-Schaltung, mit
- einem spannungsgesteuerten Hauptoszillator (VCO1), dem eingangsseitig ein von dem Modulationssignal abgeleitetes Steuersignal und ein Fehlersignal zuführbar sind und der ausgangsseitig ein winkelmoduliertes Ausgangssignal der PLL-Schaltung liefert,
- einem Schleifenteiler (ST), der dem Hauptoszillator (VCO1) nachgeschaltet ist und einen Schleifenteilerfaktor (N_{S}) hat,
- einem Phasenvergleicher (PD), dessen Eingängen der Ausgang des Schleifenteilers (ST) und ein von dem Modulationssignal abgeleitetes Vergleichsfrequenzsignal zuführbar sind,
- einem Schleifenfilter (SF), das dem Phasenvergleicher (PD) nachgeschaltet ist und das Fehlersignal liefert,
- einen spannungsgesteuerten Referenzoszillator (VCO2), und
- einem dem Referenzoszillator (VCO2) nachgeschalteten Referenzteiler (RT) mit einem Referenzteilerfaktor (N_{E}), der das Vergleichsfrequenzsignal für den Phasenvergleicher (PD) liefert,
gekennzeichnet durch
- ein erstes Kompensationsfilter (F1), dem eingangsseitig das Modulationssignal zuführbar ist und das ausgangsseitig mit dem Steuereingang des Referenzoszillators (VCO2) verbunden ist und dessen Übertragungsfunktion (F_{X1}(s)) proportional zu dem Referenzteilerfaktor (N_{E}) und umgekehrt proportional zu dem Schleifenteilerfaktor (N_{S}) und der Abstimmsteilheit (K_{E}) des Referenzoszillators (VCO2) ist, und
- ein zweites Kompensationsfilter (F2), dem eingangsseitig das Modulationssignal zuführbar ist, das ausgangsseitig das Steuersignal liefert und dessen Übertragungsfunktion (F_{X2}(s)) umgekehrt proportional zu der Abstimmsteilheit (K₀) des Hauptoszillators (VCO1) ist.

2. PLL-Schaltung nach Anspruch 1, gekennzeichnet durch
- ein Datentiefpaßfilter (DTP), das dem zweiten Kompensationsfilter (F2) nachgeschaltet ist.

3. PLL-Schaltung nach Anspruch 1 oder 2, gekennzeichnet durch
- einen Addierer (ADD), dem eingangsseitig das Steuersignal und das Fehlersignal zuführbar sind und der ausgangsseitig an den Steuereingang des Hauptoszillators (VCO1) angeschlossen ist.

4. PLL-Schaltung nach einem der Ansprüche 1 bis 3, dadurch gekennzeichnet,
- daß die Übertragungsfunktion (F_{X1}(s)) des ersten Kompensationsfilters (F1) ferner proportional zu dem Frequenzhub (Delta F) des Referenzoszillators (VCO2) ist.

5. PLL-Schaltung nach einem der Ansprüche 1 bis 4, dadurch gekennzeichnet,
- daß die Übertragungsfunktion (F_{X2}(s)) des zweiten Kompensationsfilters (F2) ferner proportional zu dem Frequenzhub (Delta F) des Hauptoszillators (VCO1) ist.

## Claims

1. A PLL circuit modulatable by a modulation signal having a direct current component, comprising
- a voltage-controlled main oscillator (VCO1) which is adapted to have supplied thereto on its input side a control signal derived from the modulation signal as well as an error signal and which supplies on its output side an angle-modulated output signal of the PLL circuit,
- a loop divider (ST) which is connected downstream of said main oscillator (VCO1) and which has a loop-divider factor (N_{S}),
- a phase comparator (PD) whose inputs are adapted to have supplied thereto the output of the loop divider (ST) and a reference frequency signal derived from the modulation signal,
- a loop filter (SF) which is connected downstream of the phase comparator (PD) and which supplies the error signal,
- a voltage-controlled reference oscillator (VC02), and
- a reference divider (RT) with a reference divider factor (N_{E}), which is connected downstream of the reference oscillator (VC02) and which supplies the reference frequency signal for the phase comparator (PD),
characterized by
- a first compensation filter (F1) whose input side is adapted to have supplied thereto the modulation signal and whose output side is connected to the control input of the reference oscillator (VC02), the transfer function (F_{X1}(s)) of said first compensation filter (F1) being proportional to the reference divider factor (N_{E}) and inversely proportional to the loop-divider factor (N_{S}) and the tuning slope (K_{E}) of the reference oscillator (VC02), and
- a second compensation filter (F2) whose input side is adapted to have supplied thereto the modulation signal and whose output side supplies the control signal, the transfer function (F_{X2}(s)) of said second compensation filter (F2) being inversely proportional to the tuning slope (K_{O}) of said main oscillator (VC01).

2. A PLL circuit according to claim 1, characterized by
- a data lowpass (DTP) connected downstream of said second compensation filter (F2).

3. A PLL circuit according to claim 1 or 2, characterized by
- an adder (ADD) whose input side is adapted to have supplied thereto the control signal and the error signal and whose output side is connected to the control input of the main oscillator (VC01).

4. A PLL circuit according to one of the claims 1 to 3, characterized in
- that the transfer function (F_{X1}(s)) of the first compensation filter (F1) is, in addition, proportional to the frequency shift (delta F) of the reference oscillator (VCO2).

5. A PLL circuit according to one of the claims 1 to 4, characterized in
- that the transfer function (F_{X2}(s)) of the second compensation filter (F2) is, in addition, proportional to the frequency shift (delta F) of the main oscillator (VCO1).

## Revendications

1. Circuit PLL modulable par un signal de modulation comportant une composante de courant continu, avec
- un oscillateur principal commandé par la tension (VCO1), vers lequel peuvent être alimentés, du côté de l'entrée, un signal de commande dérivé du signal de modulation et un signal de défaut et qui fournit, du côté de la sortie, un signal de sortie à modulation angulaire du circuit PLL,
- un diviseur à boucle (ST) qui est connecté en aval de l'oscillateur principal (VCO1) et a un facteur de diviseur à boucle (N_{S}),
- un comparateur de phases (PD), vers les entrées duquel peuvent être alimentés la sortie du diviseur à boucle (ST) et un signal de fréquence de comparaison dérivé du signal de modulation,
- un filtre à boucle (SF) qui est connecté en aval du comparateur de phases (PD) et fournit le signal de défaut,
- un oscillateur de référence commandé par la tension (VCO2), et
- un diviseur de référence (RT), connecté en aval de l'oscillateur de référence (VCO2), à facteur de diviseur de référence (NE), qui fournit le signal de fréquence de comparaison pour le comparateur de phases (PD),
caractérisé par
- un premier filtre de compensation (F1), vers lequel peut être alimenté, du côté de l'entrée, le signal de modulation et qui est relié, du côté de la sortie, à l'entrée de commande de l'oscillateur de référence (VCO2) et dont la fonction de transmission (F_{X1}(s)) est proportionnelle au facteur de diviseur de référence (N_{E}) et inversément proportionnelle au facteur de diviseur à boucle (N_{S}) et à la pente de réglage (K_{E}) de l'oscillateur de référence (VCO2), et
- un second filtre de compensation (F2), vers lequel peut être alimenté, du côté de l'entrée, le signal de modulation, qui fournit, du côté de la sortie, le signal de commande et dont la fonction de transmission (F_{X2}(s)) est inversément proportionnelle à la pente de réglage (K_{O}) de l'oscillateur principal (VCO1).

2. Circuit PLL suivant la revendication 1, caractérisé par
- un filtre passe-bas de données (DTP) qui est connecté en aval du second filtre de compensation (F2).

3. Circuit PLL suivant la revendication 1 ou 2, caractérisé par
- un additionneur (ADD), vers lequel peuvent être alimentés, du côté de l'entrée, le signal de commande et le signal de défaut et qui est raccordé, du côté de la sortie, à l'entrée de commande de l'oscillateur principal (VCO1).

4. Circuit PLL suivant l'une des revendications 1 à 3, caractérisé en ce que la fonction de transmission (F_{X1}(s)) du premier filtre de compensation (F1) est, par ailleurs, proportionnelle à la déviation de fréquence (Delta F) de l'oscillateur de référence (VCO2).

5. Circuit PLL suivant l'une des revendications 1 à 4, caractérisé en ce que la fonction de transmission (F_{X2}(s)) du second filtre de compensation (F2) est, par ailleurs, proportionnelle à la déviation de fréquence (Delta F) de l'oscillateur principal (VCO1).
